# EUROPÄISCHE PATENTANMELDUNG

(11) **EP 0 592 888 A2**
(43) Veröffentlichungstag der Anmeldung: **20.04.1994**
(21) Anmeldenummer: 93115852.1
(22) Anmeldetag: 30.09.1993
(51) Int. Cl.: H03K 17/95, H03K 17/945

(54) **Sicherheitssensor**

(30) Priorität: 30.09.1992 DE 4232804
(71) Anmelder: EGE GmbH, D-24214 Gettorf (DE)
(72) Erfinder: Hiss, Eckart, Dr., D-24105 Kiel (DE)
(74) Vertreter: Hansmann, Dierk, Dipl.-Ing.

(57) **Zusammenfassung**

Der Sicherheitssensor ist als berührungslos arbeitender Näherungsinitiator aufgebaut mit einer in einem Gehäuse eingebauten Schwingspulenanordnung, die von einem Os - zillator angeregt ist, mit einem Verstärker, der die Zustandsänderung des Oszillators in ein elektrisches Signal umsetzt und mit einem metallsichen Betätigungsteil, das den Schwingzustand des Oszillators bei Annäherung an die stirnseitig im Initiatorgehäuse eingebaute Schwingspulenanordnung ändert. Der Verstärker weist zwei Schaltausgänge auf, von denen bei Betätigung mit einem Betätigungsteil der erste Schaltausgang immer den entgegengesetzten Schaltzustand des zweiten Schaltausgangseinnimmt. Bei einer Fehlfunktion der Schwingspulenanordnung haben beide Schaltausgänge denselben Zustand.

## Beschreibung

Die Erfindung betrifft einen Sicherheitssensor, der als herührungslos arbeitender Näherungsinitiator aufgebaut ist, mit einer in einem Gehäuse eingebauten Schwingspulenanordnung, die von einem Oszillator angeregt ist, mit einem Verstärker, der die Zustandsänderung des Oszillators in ein elektrisches Signal umsetzt und mit einem metallischen Betätigungsteil, das den Schwingzustand des Oszillators bei Annäherung an die stirnseitig im Initiatorgehäuse eingebaute Schwingspulenanordnung ändert, mit einem Verstärker, der zwei Schaltausgänge aufweist, von denen bei Betätigung mit einem Betätigungsteil der erste Schaltausgang immer den entgegengesetzten Schaltausgang wie der zweite Schaltzusgang aufweist.

In vielen Bereichen der Automatisierungstechnik ist es zunehmend erforderlich, den elektrischen Zustand eines in einer Maschine eingesetzten Sensors zu überwachen und eindeutige Informationen darüber zu erhalten, ob die Funktion dieses Sensors gewährleistet ist oder nicht. Um solche eindeutigen Aussagen zu erhalten, gibt es verschiedene Lösungsmöglichkeiten. Die einfachste Art, zu einer eindeutigen Aussage zu gelangen, besteht darin, völlig gleichartige Sensoren dieselbe Erfassungsfunktion zuzuordnen. Die Ausgangssignale dieser Sensoren werden miteinander verglichen.

Ergibt sich hier ein Widerspruch, wobei von mindestens drei Sensoren auszugehen ist, muß auf einen Fehler geschlossen werden. Ein für diese Anwendüngen typischer Sensor ist in der DE 4023 502 A1 beschrieben. Solche technischen Lösungen sind in der Regel insbesondere bei beengten Einbauverhältnissen nicht realisierbar, so daß in den meisten Fällen auf ein anderes Verfahren zurückgegriffen wird. Bei diesen Verfahren wird dem eigentlichen Detektionssignal ein Code überlagert, der in einer kontinuierlichen Signalunterbrechung in Form einer Codierung besteht oder es wird dem eigentlichen Meßsignal ein Zusatzsignal überlagert. Auch sind Verfahren bekannt, die nach Aussendung eines Primärsignals die zeitlich verschobene Antwort des zu erfassenden Materials auswerten. In der Schrift DE 39 34 593 ist ein Verfahren aufgezeigt, in dem diese Aufgabe dadurch gelöst ist, daß in einer Spulenanordnung, die innerhalb des Initiatorgehäuses eingebaut ist, eine Signalwandlung zwischen einem Generatorsignal und dem eigentlichen Detektorsignal stattfindet. Durch elektronische Auswertung der Hüllkurve, die dem Generatorsignal eindeutig zugeordnet ist, ist eine Identifizierung eines Fehlers in der Spulenanordnung und auch in dem nachfolgenden Verstärker eindeutig möglich, sofern wiederum der Hüllkurvendetektor hinreichend sicher ausgeführt ist.

Alle bislang bekannten Anordnungen bedürfen einer aufwendigen elektronischen Auswertung und sind mit einfachen Mitteln nicht in einem Sensorgehäuse unterzubringen.

Aufgabe der Erfindung war es, einen Sensor zu entwerfen, der insbesondere die Funktion der Schwingspulenanordnung in der Weise überwacht und meldet, daß der logische Schaltausgang des Initiators den vorliegenden Fehler eindeutig signalisiert.

Die gestellte Aufgabe ist zunächst dadurch gelöst, daß ein Näherungsinitiator verwendet ist, der zwei Schaltausgänge aufweist, die im nicht gestörten Fall immer den entgegengesetzten Schaltzustand ausweisen, d.h. daß ein Schaltausgang immer gesperrt ist, während der andere durchschaltet. Bei Betätigung durch ein Betätigungselement wechseln diese Schaltausgänge entsprechend. In einer dem Initiator nachgeschalteten Auswertungselektronik, die in der Regel aus einer elektronischen Steuerung besteht, werden die Schaltzustände kontinuierlich überwacht. Die Steuerung ist so programmiert, daß grundsätzlich beide Ausgänge gleichzeitig wechseln müssen und zueinander komplementär sind. Sind diese Bedingungen nicht erfüllt, wird eine Störmeldung ausgelöst.

Erfindungsgemäß ist daher innerhalb der Initiatorelektronik ein Schaltkreis vorgesehen, der beide Schaltausgänge des Initiators in den gleichen Zustand, geöffnet oder gesperrt, überführt. Dieser Schaltkreis besteht im einfachsten Fall aus einem Spannungskomparator, der an den Oszillatorverstärker angeschlossen ist, und dessen Ausgang an einen weiteren elektrischen Schaltkreis angeschlossen ist, der den Schaltzustand eines der beiden Schaltausgänge das Schaltverstärkers in den entgegengesetzten Schaltzustand schaltet. Eine besonders einfache Lösung besteht darin, daß der Spannungskomparator an den Meßeingang des Schaltverstärkers angeschlossen ist, der im Fall eines Überstromes oder Kurzschlusses die beiden Schaltausgänge in den gesperrten Zustand schaltet. In der Regel werden insbesondere für Nëherungsinitiatoren integrierte Scheltkreise verwendet, in die dem Oszillatorverstärker,der Demodulator und der Schaltverstärker sowie ein Kurzschlußdetektor integriert sind. Tritt ein Überstrom oder ein Kurzschluß in einem Zweige der Schaltausgänge auf, so wird dieser Überstrom an einem Meßwiderstand in eine Spannung umgewandelt, die dem Meßeingang des integrierten Schaltkreises zugeführt ist, der seinerseits die Ansteuerung der angeschlossenen Schalttransistoren unterbindet, d.h. diese solange sperrt, wie an seinem Eingang eine Signalspannung anliegt. Dieser Eingang kann naturgemäß nicht zwischen einem Kurzschlußsignal und einem Abschaltsignal unterscheiden, so daß dies ein sehr geeigneter und einfacher Anschlußpunkt für die Überführung der Schaltausgänge in einen gleichartigen Schaltzustand ist.

Die Schwingspulenanordnung ist an einen Oszillatorverstärker angeschlossen, dessen innere Spannungspegel so ausgelegt sind, daß sie vom Innenwiderstand der Schwingspule abhängig sind. Verändert sich dieser Schwingspulenwiderstand signifikant, so verschieben sich innerhalb des Oszillatorverstärkers die verschiedenen Gleichspannungspotentiale entsprechend. Der Aufbau des Oszillatorverstärkers ist zudem so ausgelegt, daß die Schwingungen der vorzugsweise als Parallelresonanzkreis ausgelegten Anordnung einem internen Gleichspannungspegel des Oszillatorverstärkers Überlagert sind. Durch einfache schaltungstechnische Maßnahmen lassen sich dar Gleichspannungs- und der Wechselspannungsanteil innerhalb des Oszillators voneinander trennen. Auf diese Weise gelingt es, die Spulenanordnung eines Oszillatorverstärkers zu überwachen, ohne daß dies vom Schwingzustand der Spulenanordnung abhängig wäre. Dem Komparatorverstärker wird daher die von der Oszillatoramplitude getrennte Signalgleichspannung des Oszillatorverstärkers zugeführt. Wie eingangs beschrieben, ist dieser Signalgleichspannungspegel jedoch abhängig vom Innenwiderstand der Spulenanordnung. Erfindungsgemäß ist daher ein eindeutiger Zusammenhang zwischen einer durch Umwelteinflüsse,insbesondere mechanisch beschädigten Schwingspulenanordnung, gegeben, wobei die Überwachung der Schwingspulenanordnung sowohl im schwingenden wie auch im nicht schwingenden Zustand sichergestellt ist.

Es gibt jedoch auch Beschädigungen einer Schwingspulenanordnung, insbesondere wenn diese einen ferritischen Kern enthält, die nicht zu einer Widerstandsänderung der Schwingspule selbst führen. In solchem Fall liegen jedoch signifikante Änderungen der Grundfrequenz der Schwingspulenanordnung, die an den Oszillatorvarstärker angeschlossen ist, vor. Erfindungsgemäß wird daher auch die Frequenz des Oszillatorverstärkers dadurch überwacht, daß ein zweiter Oszillator vorhanden ist, der dieselbe Frequenz aufweist und in einer Frequenzvergleichsschaltung bei Über- oder Unterschreiten einer Frequenzschwelle über den Komparator, der in einem solchen Falle vorzugsweise als Fensterkomparator ausgebildet ist, ein Steuersignal abgibt. Diesem Fensterkomparator kann erfindungsgemäß auch ein von dem Oszillatorverstärker abgegebenes analoges Signal zugeführt sein, das in monotoner Weise dem Betätigungsabstand eines Sensorelementes zur Ansprechfläche des Initiators entspricht. Ist der Schwingzustand des Oszillatorverstärkers insbesondere so ausgelegt, daß bei völliger Annäherung des Betätigungsteiles noch eine Restschwingamplitude vorhanden ist, so kann das analoge Oszillatorsignal, das von dieser Restschwingamplitude abgeleitet ist, als untere Ansprechschwelle für eine Fehlfunktionsmeldung verwendet werden, weil es bei einem so ausgelegten Oszillator nicht zulässig ist, daß die Oszillatoramblitude kleiner ist als die durch eine volle Annäherung eines Metallteils erzeugte kleinste Amplitude. Insbesondere wird auch bei Beschädigung des Ferritkernes für den oben geschilderten Betätigungszustand eine Unterschreitung der unteren Schwelle für das demodulierte Oszillatorsignal eintreten. Die weitere Ausbildung der Erfindung wird an den nachfolgenden Ausführungsbeispielen näher erläutert.

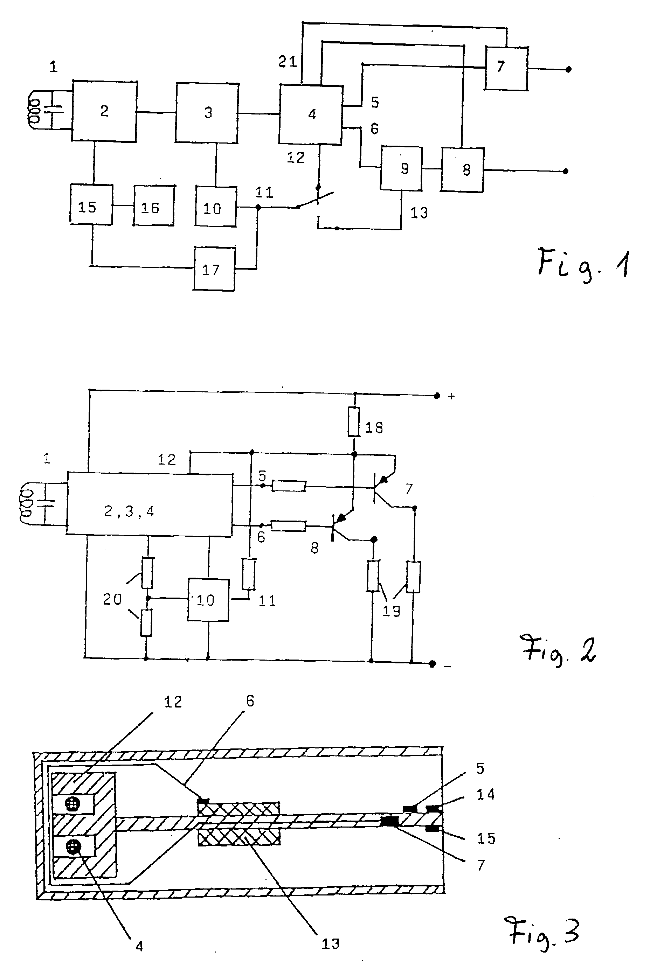

Die Schwingspulenanordnung (1) ist in Abb 1 an einen Oszillatorverstärker (2) angeschlossen, dem ein weiterer Verstärker und Demulator (3) folgt. Das so aufbereitete Signal wird dem Schaltverstärker (4) zugeführt, der zwei komplementäre Schaltausgänge (5, 6) aufweist, die ein komplementäres Schaltverhalten aufweisen, d.h. wenn zum Beispiel der Schaltausgang 5 durchgeschaltet ist, ist der Schaltausgang 6 gesperrt. Diese Schaltausgänge werden den Schaltendstufen (7, 8) zugeführt, die ihrerseits als Transistoren oder Thyristoren wie auch als Relais ausgeführt sein können. Der Endstufe (8) ist ein Schaltkreis (9) vorgeschaltet, der bei Betätigung seines Eingangs (13) sein Signal zwischen Eingang und Ausgang logisch umkehrt. Der Schaltverstärker (4) weist drei Eingänge für ein Steuersignal auf, die die beiden Ausgänge (5, 6) in den gesperrten Zustand versetzen. Die Eingänge (21) sind die Überstrommeßeingänge für die Schaltendstufen (7 und 8). Der Meßeingang (12) ist ein zusätzlicher Eingang, der durch eine Beaufschlagung mit einer Gleichspannung ebenfalls die Ausgänge (5, 6) in den gesperrten Zustand versetzt. Die Ausgänge der Komparatoren (10, 17) sind ggfs. unter Zwischenschaltung entkoppelnder Bauelemente im Punkt (11) zusammengeschaltet. Dieser Punkt (11) kann wahlweise an den Meßeingang (12) des Schaltverstärkers (4) angeschlossen sein oder an den Steuereingang (13) des Schaltkreises (9). Der Komparator (10) ist an den Demodulatorverstärker (3) angeschlossen. Der Komparator (17) an die Frequenzvergleichsschaltung (15), die ihrerseits mit einem in seiner Frequenz verstellbaren Oszillator (16) und dem Schwingspulenoszillator (2) verbunden ist.

In Abb. 2 ist eine sehr einfache Realisierung dargestellt. Hier bestehen der Oszillatorverstärker (2), der Demodulatorverstärker (3) und der Schaltverstärker (4) aus einem integrierten Schaltkreis, an den die Schwingspulenanordnung (1) angeschlossen ist. Der für den Schwingzustand typische Gleichspannungsanteil wird über einen Spannungsteiler (20),dem Komparator (10) zugeführt, der mit seinem Ausgang (11) an den Stromdetektorausgang (12) des integrierten Schaltkreises angeschlossen ist. Der Komparator (10) bezieht seine Referenzspannung vorzugsweise aus dem integrierten Schaltkreis. Die Ausgänge (5, 6) sind auf Transistoren geführt, die einen gemeinsamen Strommeßwiderstand (18) aufweisen. Die Ausgänge der Transistoren (7,8) sind auf die Lastwiderstände (19) geschaltet. In dieser Schaltung sind nur die wesentlichen für die funktion bestimmenden Kom - ponenten aufgezeigt. Schaltungstechnische Einzelheiten insbesondere die Invertierung von Signalen, die Entkoppelung einzelner Schaltkreise, sowie Komponenten zur Entstörung und Impulsunterdrückung wurden nicht dargestellt.

In einer Weiterbildung der Erfindung kann die vorstehende technische Lehre auch auf allgemeine Sensorsysteme übertragen werden, die einen physikalischen Zustand in ein elektrisches Signal umsetzen, wie dies z.B. außer bei den beschriebenen induktiven Systemen auch bei akustischen , optischen,kapazitiven oder wärmeleitenden Wirkungs - prinzipien der Fall ist. Anstelle der direkten Überwachung des Sensorelementes oder Sensorsystems kann dies auch indirekt, z.B. im einfachsten Fall durch einen um das Sensorelement gewickelten Einzeldraht geschehen. Die Durchtrennung dieses Drahtes, der z.B. auch als ein Leiterbahnzug einer Leiterplatte ausgebildet sein kann, wird in ein elektrisches signal gewandelt,, das seinerseits den Schaltverstärker, wie eingangs beschrieben ist betätigt. Anstelle dieser teilmechanischen Überwachung, die wie eine Schmelzsicherung wirkt, kann auch ein den Betriebszustand des sensorischen Systems elektrisch abtastenden Meßsystems verwendet werden.

In Figur 3 ist schematisch ein induktiver Näherungsschalter gezeigt, der aus einem Gehäuse 1, einer Leiterbahnplatte 3, einer Sensorspüle 4, die in einen Ferritkern eingebracht ist 12, und aus die elektrischen Signale auswertenden elektronischen Komponenten 13 besteht. An die elektronischen Komponenten 13 ist die insbesondere hier der dem stirnseitigen Schutz des Sensors dienende Leiterbahn 6 angeschlossen. Sie beeinflußt den Verstärker dieses Sensors in der Weise, daß bei einer Unterbrechung der Leiterbahn 6 zwei Schaltauggänge des Sensors 14, 15 denselben Schaltzustand einnehmen. Die Leiterbahn kann auch direkt in Randnähe des platten - förmigen Bauelementträgers weitergeführt sein.

## Patentansprüche

1. Sicherheitssensor, der als berührungslos arbeitender Nährungsinitiator aufgebaut ist, mit einer in einem Gehäuse eingebauten Schwingspulenanordnung, die von einem Oszillator angeregt ist, mit einem Verstärker, der die Zustandsänderung des Oszillators in ein elektrisches Signal umsetzt und mit einem metallischen Betätigungsteil, das den Schwingzustand des Oszillators bei Annäherung an die stirnseitig im Initiatorgehäuse eingebaute Schwingspulenanordnung ändert, mit einem Verstärker, der zwei Schaltausgänge aufweist, von denen bei Betätigung mit einem Betätigungsteil der erste Schaltausgang immer den entgegengesetzten Schaltzustand, gesperrt-durchgeschaltet, des zweiten Schaltausgangs einnimmt, dadurch gekennzeichnet, daß bei einer Fehlfunktion der Schwingspulenanordnung beide Schaltausgänge denselben Schaltzustand haben.

2. Sicherheitssensor nach Anspruch 1 dadurch gekennzeichnet, daß an den Oszillatorverstärker ein Spannungskomparator angeschlossen ist, dessen Ausgang vermittels eines elektrischen Schaltkreises den Schaltzustsnd eines der beiden Schaltausgänge des Schaltverstärkers in den entgegengesetzten Zustand schaltet.

3. Sicherheitssensor nach Anspruch 1 und 2 dadurch gekennzeichnet, daß der Ausgang des Spannungskomparators an den Meßeingang des Schaltverstärkers angeschlossen ist, der im Fall eines Überstromes oder Kurzschlusses die Schaltausgänge in den gesperrten Zustand schaltet.

4. Sicherheitssensor nach Anspruch 1 dadurch gekennzeichnet, daß eine Frequenzvergleichsschaltung vorgesehen ist, die an den Oszillator angeschlossen ist, und die ihrerseits mit einem Frequenz einstellbaren Oszillator verbunden ist.

5. Sicherheitssensor nach Anspruch 4 dadurch gekennzeichnet, daß der Spannungskomparator nach Anspruch 2 und 3 an den Ausgang der Frequenzvergleichsschaltung angeschlossen sind.

6. Sicherheitssensor nach einem oder mehreren der Ansprüche 1 bis 5 dadurch gekennzeichnet, daß die Beeinflussung der Schwingspulenanordnung durch den Oszillatorverstärker in ein der Beeinflussung monoton folgendes elektrisches Signal umgesetzt ist.

7. Sicherheitssensor nach Anspruch 2 und 3, dadurch gekennzeichnet, daß der Komparator als Fensterkomparator ausgeführt ist, der eine obere und untere Schwelle für das elektrische Eingangssignal aufweist, wobei die Über- oder Ünterschreitung der Schwellen einen Spannungssprung am Ausgang des Fensterkomparators auslöst.

8. Sicherheitssensor nach einem oder mehreren der Ansprüche 1 - 7, dadurch gekennzeichnet, daß der Oszillatorverstärker so ausgelegt ist, daß er einen Signalgleichspannungspegel-Anachluß besitzt, an dem eine Spannung anliegt, die vom Innenwiderstand der an den Oszillatorverstärkar angeschlossenen Schwingspule beeinflußt ist.

9. Sicherheitssensor nach einem oder mehreren der Ansprüche 1-8, dadurch gekennzeichnet, daß die Schwingspulenanordnung, der Oszillator und das Betätigungsteil durch ein durch die Umgebungsbedingungen be - einflußtes Sensorzystem ersetzt sind, das ein kapazitives, optisches akustisches oder wärmeleitendes Wirkungsprinzip aufweist.

10. Sicherheitssensor nach einem oder mehreren der Ansprüche 1-9, dadurch gekennzeichnet, daß an den Schaltverstärker ein den Betriebszustand des Sensorsystems elektrisch oder mechanisch überwachenden Meßsystems angeschlossen ist.
